(19) Europäisches Patentamt

European Patent Office

Office européen des brevets

(11) **EP 1 269 632 B1**

(12) **EUROPÄISCHE PATENTSCHRIFT**

(45) Veröffentlichungstag und Bekanntmachung des Hinweises auf die Patenterteilung:
**29.12.2004   Patentblatt 2004/53**

(21) Anmeldenummer: 01923515.9

(22) Anmeldetag: **12.03.2001**

(51) Int Cl.⁷: $H03M\ 1/00$, $H03M\ 13/29$

(86) Internationale Anmeldenummer:
**PCT/DE2001/000982**

(87) Internationale Veröffentlichungsnummer:
**WO 2001/069788 (20.09.2001 Gazette 2001/38)**

(54) **TURBO-DECODIERER UND TURBO-DECODIERVERFAHREN**

TURBO DECODER AND TURBO DECODING METHOD

DECODEUR TURBO ET PROCEDE DE DECODAGE TURBO

(84) Benannte Vertragsstaaten:
**AT BE CH CY DE DK ES FI FR GB GR IE IT LI LU MC NL PT SE TR**

(30) Priorität: **16.03.2000  DE 10012874**

(43) Veröffentlichungstag der Anmeldung:
**02.01.2003   Patentblatt 2003/01**

(73) Patentinhaber: **Infineon Technologies AG**
**81669 München (DE)**

(72) Erfinder:
• **BECKER, Burkhard**
  **85737 Ismaning (DE)**
• **JUNG, Peter**
  **67697 Otterberg (DE)**
• **PLECHINGER, Jörg**
  **80469 München (DE)**
• **SCHNEIDER, Michael**
  **81541 München (DE)**
• **DOETSCH, Markus**
  **CH-3098 Schliern (CH)**
• **KELLA, Tideya**
  **80337 München (DE)**
• **SCHMIDT, Peter**
  **67167 Erpolzheim (DE)**

(74) Vertreter: **Lange, Thomas, Dr.**
**Patentanwälte**
**Lambsdorff & Lange**
**Dingolfinger Strasse 6**
**81673 München (DE)**

(56) Entgegenhaltungen:
• **MASERA G ET AL: "VLSI architectures for turbo codes" IEEE TRANS. VERY LARGE SCALE INTEGR. (VLSI) SYST. (USA), IEEE TRANSACTIONS ON VERY LARGE SCALE INTEGRATION (VLSI) SYSTEMS, SEPT. 1999, IEEE, USA, Bd. 7, Nr. 3, September 1999 (1999-09), Seiten 369-379, XP002187339 ISSN: 1063-8210**

**Beschreibung**

Die Erfindung betrifft einen Turbo-Decodierer zum Decodieren eines senderseitig mit einem Turbo-Code fehlerschutzcodierten, über einen gestörten Kanal übertragenen und in einem Empfänger detektierten Datensignals nach dem Oberbegriff des Anspruchs 1. Ferner betrifft die Erfindung ein Turbo-Decodierverfahren nach dem Oberbegriff des Anspruchs 7.

Ein Grundproblem der Nachrichtentechnik besteht darin, ein Datensignal möglichst fehlerfrei über einen gestörten Kanal zu übertragen. Um dies zu erreichen, wird das zu übertragende Datensignal einer Kanalcodierung unterzogen. Durch die Kanalcodierung wird das zu übertragende Signal an die Eigenschaften des Übertragungskanals angepaßt. Es sind eine Vielzahl unterschiedlicher Kanalcodierverfahren im Einsatz. Das Prinzip der Kanalcodierung (die auch als Fehlerschutzcodierung bezeichnet wird) beruht darauf, durch gezieltes Einbringen von Redundanz in das zu übertragende Signal einen effektiven Fehlerschutz zu erreichen.

Besondere Schwierigkeiten im Zusammenhang mit der Signalübertragung ergeben sich bei Mobilfunksystemen. Dies ist einerseits darauf zurückzuführen, daß bei Mobilfunksystemen aufgrund von zeitvarianten Mehrfachreflektionen, Gleichkanalstörungen, Dopplerverschiebung und Rauschen ausgesprochen starke Signalverzerrungen am Empfänger auftreten. Andererseits stehen im Empfänger einer Mobilstation aus Platz- und Kostengründen nur begrenzte Energie- und Hardware-Resourcen zur Verfügung. In der Mobilfunktechnik wird daher angestrebt, mit möglichst wenig Signalverarbeitungsaufwand (Schonung der Resource Energie) möglichst Hardware-effizient (d.h. platz- und kostengünstig) eine Rekonstruktion des gesendeten Signals mit möglichst geringer Fehlerrate zu erreichen.

Es ist ersichtlich, daß die genannten Forderungen in der Regel nicht gleichzeitig optimierbar sind, sondern daß ein sinnvoller Ausgleich oder Kompromiß zwischen diesen Forderungen durch eine gezielte Software/Hardware-Auslegung des Empfängers geschaffen werden muß.

Ein modernes Verfahren der Fehlerschutzcodierung ist die sogenannte "Turbo-Codierung". Bei der Turbo-Codierung werden sogenannte "Turbo-Codes" eingesetzt. Turbo-Codes sind binäre, parallel verkettete rekursive Faltungscodes. Turbo-Codes stellen insbesondere bei der Übertragung großer Datenblöcke eine ausgesprochen leistungsfähige Form der Fehlerschutzcodierung dar.

Zum Decodieren von Turbo-Codes wird im Empfänger ein Turbo-Decodierer eingesetzt. Ein solcher ist in dem den nächstliegenden Stand der Technik repräsentierenden Buch "Analyse und Entwurf digitaler Mobilfunksysteme" von P. Jung, Stuttgart, B.G. Teubner, 1997, auf den Seiten 343 bis 368, insbesondere Bild E.2, beschrieben. Dieser Turbo-Decodierer besteht aus zwei rekursiv verschalteten MAP-Symbolschätzern, zwischen welchen ein Turbo-Code-Verschachteler angeordnet ist. Die Turbo-Decodierung erfolgt auf iterativem Wege, indem das zu decodierende Datensignal mehrmals eine Rechenschleife durchläuft, die die Rechenschritte erste Symbolschätzung - Verschachtelung - zweite Symbolschätzung - Entschachtelung enthält.

Ein Hindernis bei der Implementierung von Turbo-Codes besteht darin, daß Turbo-Decodierer aufgrund der iterativen Signalverarbeitung und der zwei MAP-Symbolschätzer einen beträchtlichen Signalverarbeitungs- und Hardware-Aufwand erfordern.

Bisher werden Turbo-Codes daher nur bei weniger resourcenbegrenzten Systemen, wie beispielsweise Satellitenkommunikationssystemen, eingesetzt. Im Bereich des Mobilfunks sind Turbo-Codes aufgrund der genannten Beschränkungen noch nicht im im Einsatz. Der UMTS-(Universal Mobile Telecommunications Systems-)Standard umfaßt jedoch bereits die Möglichkeit der Turbo-Codierung.

Aus der den nächstliegenden Stand der Technik bildenden Veröffentlichung "VLSI Architectures for Turbo Codes", Guido Masera et al., IEEE Transactions on Very Large Scale Integration Systems, Vol. 7, No. 3, September 1999, Seiten 369 - 379, sind verschiedene Architekturen für Turbo-Decodierer für Satellitenkommunikationssysteme bekannt. Ein in dieser Schrift näher vorgestellter Turbo-Decodierer umfasst vier Hardware-Komponenten: zwei SISO-Dekodierer (soft-input soft-output), einen Interleaver und einen Deinterleaver. Zur Reduzierung des Hardware-Aufwands wird vorgeschlagen, für den Interleaver und den Deinterleaver jeweils nur einen RAM-Speicher mit $N_{int}$ Speicherworten statt zweier RAM-Speicher derselben Größe zu verwenden. Dabei entspricht $N_{int}$ der Interleaving-Länge.

Der Erfindung liegt die Aufgabe zugrunde, einen Turbo-Decodierer sowie ein Verfahren zur Decodierung eines Turbo-Codes zu schaffen, der bzw. das bei vertretbarem Hardware-Aufwand eine signalverarbeitungsarme und damit Energieresourcen-schonende Signaldecodierung ermöglicht. Insbesondere soll der erfindungsgemäße Turbo-Decodierer sowie das erfindungsgemäße Turbo-Decodierverfahren die Implementierung von Turbo-Codes im Bereich des Mobilfunks ermöglichen.

Zur Lösung der Aufgabe sind die Merkmale der Ansprüche 1 und 6 vorgesehen.

Demnach besteht das Konzept der Erfindung darin, durch eine gezielte Aufteilung der (als solche bereits bekannten) Rechenschritte einer Rechenschleife, die bei einer iterativen Decodierung eines Turbo-Codes mehrfach zu durchlaufen ist, auf zwei unterschiedliche Rechenmittel eine Resourcenökonomischere Abarbeitung der Rechenschleife zu ermöglichen. Im Rahmen der Erfindung wurde festgestellt, daß die durch diese Aufteilung erreichbare Recourceneinsparung den zusätzlichen Aufwand, der durch die zweimalige bidirektionale Datenübergabe innerhalb einer Rechenschleife erforderlich wird, überkompensiert.

In bezug auf die Recource Hardware besteht der Gewinn darin, daß für die beiden Symbolschätzschritte (a) und (c) lediglich ein einziger Symbolschätzer (erstes Rechenmittel) benötigt wird, welcher zeitlich abwechselnd zur Durchführung der Rechenschritte (a) und (c) eingesetzt wird. Zur Abarbeitung der Rechenschritte (b) und (d) wird ein gesondertes zweites Rechenmittel eingesetzt, das ein eine Firmware abarbeitender digitaler Signalprozessor (DSP) ist.

Vorzugsweise werden die wenig Speicherplatz und viel Rechenaufwand beanspruchenden Rechenschritte (a) und (c) in einem ersten Rechenmittel durchgeführt, das größtenteils oder vollständig aus Hardware aufgebaut ist, während zur Abarbeitung der viel Speicherplatz und wenig Rechenaufwand erforderlichen Rechenschritte (b) und (d) der DSP eingesetzt wird. In bezug auf die Recource Energie besteht der Gewinn somit darin, daß der erfindungsgemäßen Aufteilung der Rechenschritte auf zwei Rechenmittel mit einem "Hardware-Software-Split" des Gesamtsystems entsprochen werden kann.

Eine weitere zweckmäßige Ausgestaltung der Erfindung kennzeichnet sich dadurch, daß, sofern in der Rechenschleife eine Berechnung von für den momentanen Kanalzustand repräsentativer statistischer Information durchgeführt wird, dieser Rechenschritt von dem zweiten Rechenmittel ausgeführt wird.

Vorzugsweise umfaßt das erste Rechenmittel einen ersten aus kombinatorischer Logik aufgebauten Hardware-Rechenbaustein zur Erzeugung von Übergangs-Metrikwerten und/oder einen zweiten aus kombinatorischer Logik aufgebauten Hardware-Rechenbaustein zur Erzeugung von Vorwärts- und Rückwärtsrekursions-Metrikwerten und/oder einen dritten aus kombinatorischer Logik aufgebauten Hardware-Rechenbaustein zur Erzeugung von Ausgabewerten, die repräsentativ für die Wahrscheinlichkeit sind, mit der ein zu schätzendes Datensymbol des detektierten Datensignals einen bestimmten Wert hat. Durch jeden der genannten Hardware-Rechenbausteine kann eine gezielte Beschleunigung der Signalverarbeitung bei der Berechnung der jeweiligen Werte (Übergangs-Metrikwerte; Vorwärts- und Rückwärtsrekursions-Metrikwerte; Ausgabewerte) herbeigeführt werden, d.h. daß eine zeit- und energieaufwendige Programm-Abarbeitung an dieser Stelle entfällt. Dadurch kann der gesamte Turbo-Decodier-Ablauf wesentlich beschleunigt werden.

Eine weitere vorteilhafte Ausgestaltung des erfindungsgemäßen Turbo-Decodierers kennzeichnet sich dadurch, daß die bidirektionale Schnittstelle zwei DMA-(direct memory access-)Kanälen zugeordnet ist. Die DMA-Kanäle ermöglichen jeweils einen schnellen Datentransfer zwischen den beiden Rechenmitteln, wobei es infolge der Verwendung von zwei DMA-Kanälen möglich ist, jeden DMA-Kanal für unterschiedliche Datenformate auszulegen.

Weitere vorteilhafte Ausgestaltungen der Erfindung sind in den Unteransprüchen angegeben.

Die Erfindung wird nachfolgend anhand eines Ausführungebeispiels unter Bezugnahme auf die Zeichnung erläutert; in dieser zeigt:

Fig. 1      eine schematische Darstellung der Luftschnittstelle eines Mobilfunksystems mit Sender und Empfänger;

Fig. 2      ein Blockschaltbild eines Turbo-Codierers zur Erzeugung eines Turbo-Codes;

Fig. 3      ein Blockschaltbild eines in Fig. 2 dargestellten RSC-Faltungscodierers;

Fig. 4      ein Funktions-Blockschaltbild zur Erläuterung der Arbeitsweise eines erfindungsgemäßen Turbo-Decodierers;

Fig. 5      ein Blockschaltbild des in Fig. 4 dargestellten Turbo-Decodierers;

Fig. 6      ein vereinfachtes Blockschaltbild des in Fig. 5 dargestellten MAP-Decodierers;

Fig. 7      ein Blockschaltbild der in Fig. 6 dargestellten Steuereinheit zur Erzeugung von standardspezifischer Code-Information;

Fig. 8a     ein Schaubild, in welchem die möglichen Übergänge zwischen den Anfangs- und Endzuständen eines Turbo-Codierers bei Eingabe eines Bits des Wertes 0 dargestellt sind;

Fig. 8b     ein Schaubild, in welchem die möglichen Übergänge zwischen den Anfangs- und Endzuständen eines Turbo-Codierers bei Eingabe eines Bits des Wertes 1 dargestellt sind;

Fig. 9c     ein Schaubild, in welchem vier Gruppen von Übergängen, geordnet nach den Endzuständen, dargestellt sind;

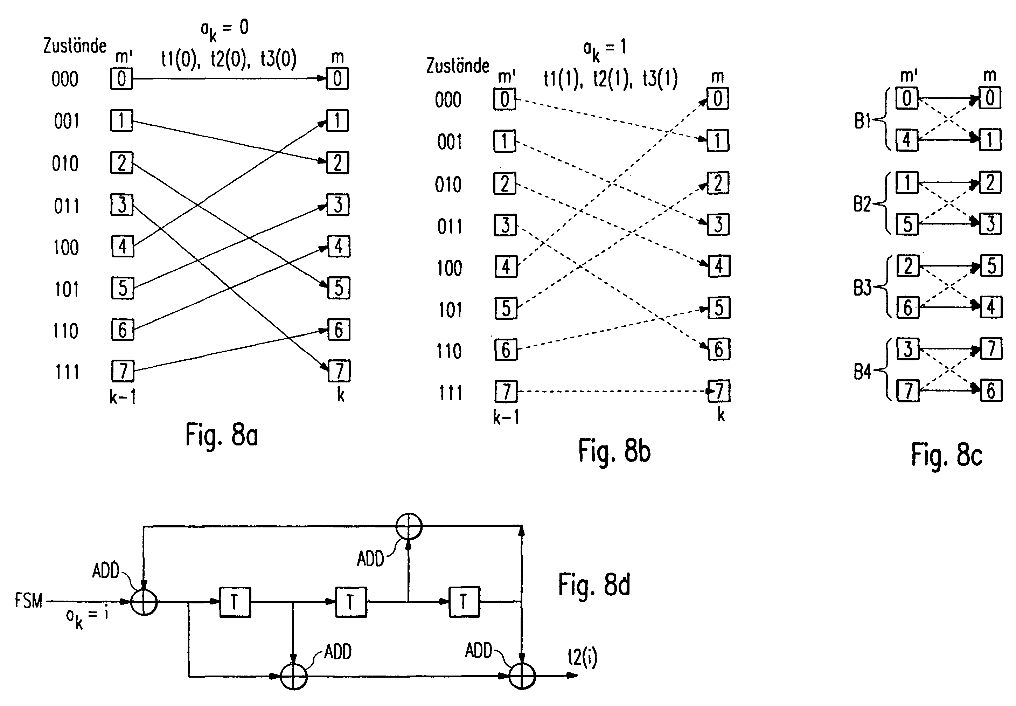

Fig. 8d    ein Blockschaltbild einer Rechenstufe zur Berechnung von theoretischer Information eines Turbo-Codes; und

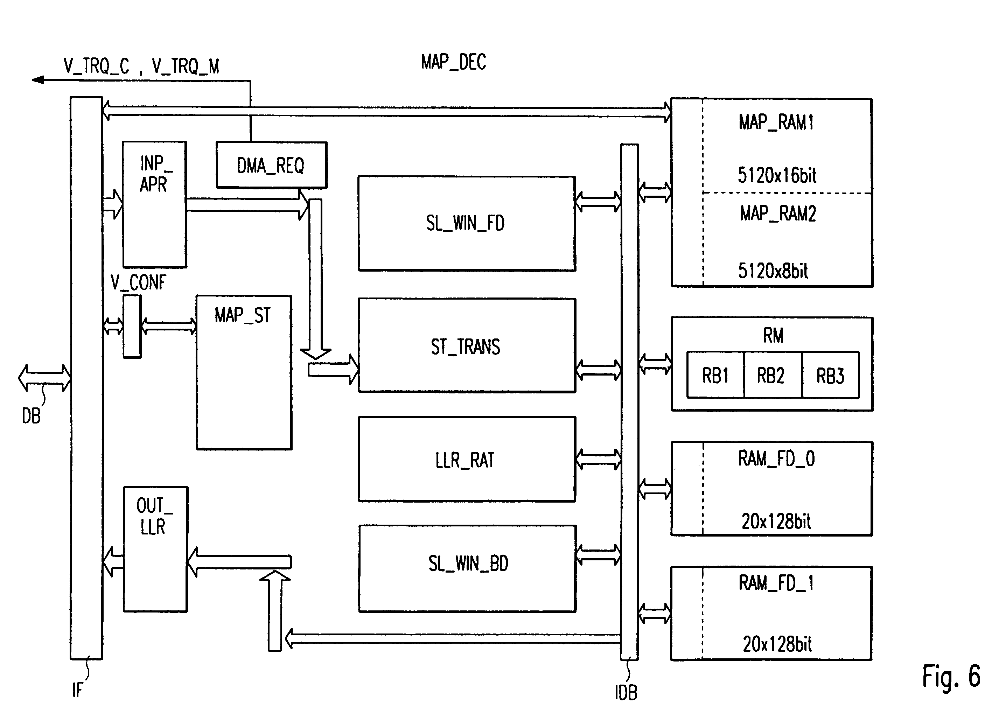

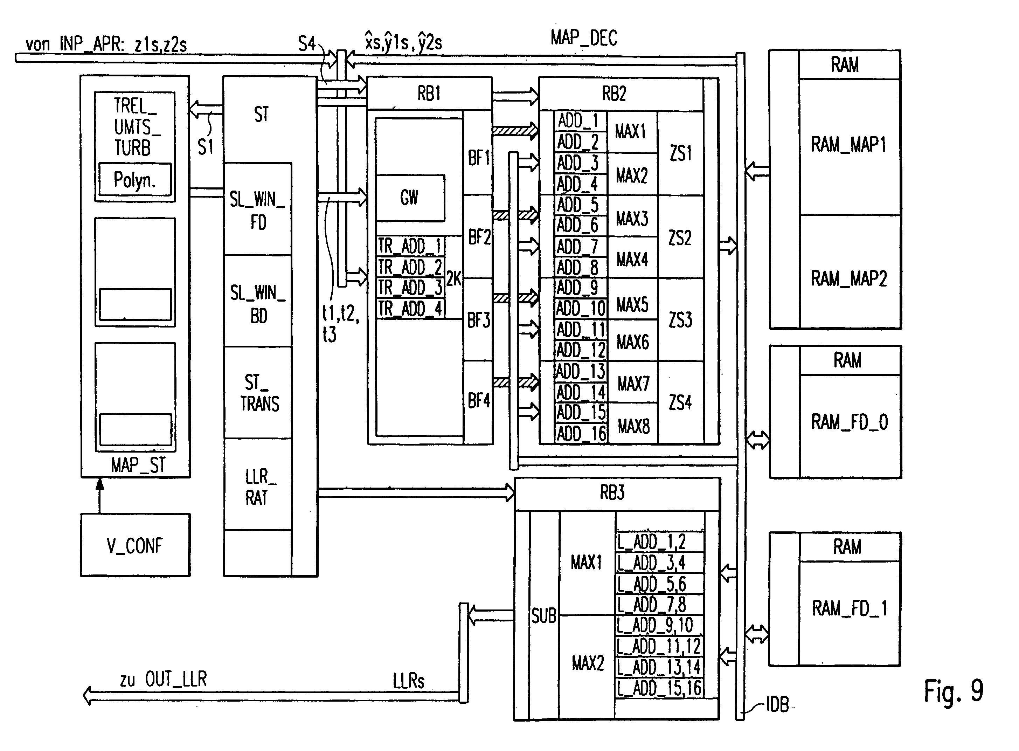

Fig. 9    ein Blockschaltbild der Hardware-Architektur des in Fig. 6 dargestellten MAP-Decodierers.

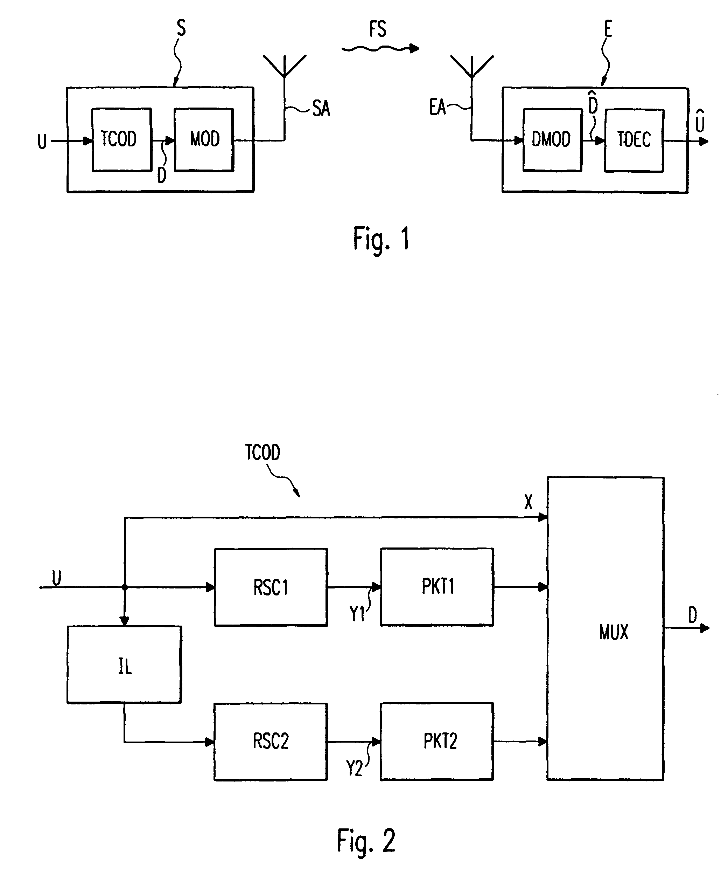

Fig. 1 zeigt einen Sender S und einen Empfänger E eines Mobilfunksystems. Der Sender S ist beispielsweise in einer Basisstation und der Empfänger E in einer Mobilstation des Mobilfunksystems enthalten.

Der Sender S weist einen Turbo-Codierer TCOD, einen Modulator MOD sowie eine Sendeantenne SA auf.

Der Turbo-Codierer TCOD nimmt ein digitales Eingabesignal in Form von Datensymbolen (beispielsweise Bits) $u_1$, $u_2$, .. entgegen. Im folgenden wird aufgrund der blockweisen Codierung eine endliche Folge U = ($u_1$, $u_2$, .., $u_N$) bestehend aus N Eingabesignal-Datensymbolen (z.B. Bits) $u_n$ , n = 1, 2, .., N betrachtet, wobei die Anzahl N als Blockgröße bezeichnet wird.

Das Eingabesignal trägt eine zu übertragende Nutzinformation, beispielsweise eine Sprachnachricht. Es kann z.B. über eine Mikrophon-Verstärker-Analog/Digital-Umsetzer Schaltungskette (nicht dargestellt) erzeugt werden.

Der Turbo-Codierer TCOD fügt dem digitalen Eingabesignal zur Fehlerschutzcodierung Redundanz hinzu. Am Ausgang des Turbo-Codierers TCOD liegt ein fehlerschutzcodiertes Datensignal in Form einer Folge D bestehend aus K Datensymbolen (Bits), D = ($d_1$, $d_2$, .., $d_K$) vor.

Das Verhältnis N/K (Anzahl von Eingabebits/Anzahl von Ausgangsbits) wird als Coderate $R_C$ eines Codierers bezeichnet.

Ein Modulator MOD moduliert das fehlerschutzcodierte Datensignal auf ein Trägersignal auf. Das mit dem fehlerschutzcodierten Datensignal modulierte Trägersignal wird in nicht dargestellter Weise von einem Sendefilter spektral geformt und von einem Sendeverstärker verstärkt, bevor es als Funksignal FS über die Sendeantenne SA abgestrahlt wird.

Der Empfänger E weist eine Empfangsantenne EA, einen Demodulator DMOD und einen Turbo-Decodierer TDEC auf.

Die Empfangsantenne EA empfängt das durch Umgebungseinflüsse und Interferenz mit Funksignalen anderer Teilnehmer gestörte Funksignal FS und führt es dem Demodulator DMOD zu.

Der Demodulator DMOD entzerrt das empfangene Funksignal FS unter Berücksichtigung der im Funkkanal erlittenen Signalstörungen. Ein am Ausgang des Demodulators DMOD bereitgestelltes entzerrtes Datensignal liegt in Form einer Datensymbolfolge D = ($d_1$, $d_2$, .., $d_K$) vor, deren Elemente $d_1$, $d_2$, .., $d_K$ wertekontinuierliche Schätzwerte der Datensymbole $d_1$, $d_2$, .., $d_K$ der fehlerschutzcodierten Datensymbolfolge D sind.

Das entzerrte Datensignal wird dem Turbo-Decodierer TDEC zugeführt, an dessen Ausgang eine decodierte Ausgabesignalfolge Û = ($\hat{u}_1$, $\hat{u}_2$, .., $\hat{u}_N$) bereitgestellt wird. Die Elemente $\hat{u}_1$, $\hat{u}_2$, .., $\hat{u}_N$ der decodierten Ausgabesignalfolge Û sind Hypothesen der Datensymbole $u_1$, $u_2$, .., $u_N$ des senderseitigen Eingabesignals in Form von diskreten Werten aus dem Symbolvorrat (beispielsweise 0,1) des Eingabesignals.

Die Datensymbol-Fehlerrate wird durch die relative Häufigkeit von Fehlschätzungen $u_n \neq \hat{u}_n$, n = 1, 2, .. definiert. Sie darf bei Mobilfunkanwendungen einen bestimmten maximal zulässigen Wert nicht überschreiten.

Vor der Beschreibung eines Ausführungsbeispiels des erfindungsgemäßen Turbo-Decodierers wird zum besseren Verständnis der Erfindung anhand Fig. 2 zunächst beispielhaft die Erzeugung eines Turbo-Codes erläutert.

Ein Turbo-Codierer TCOD weist zwei identische binäre rekursive systematische Faltungscodierer RSC1 und RSC2 auf, die in der Codiertechnik als RSC-(Recursive Systematic Convolutional-)Codierer bekannt sind. Dem zweiten RSC-Faltungscodierer RSC2 ist eingangsseitig ein Turbo-Code-Verschachteler IL vorgeschaltet, der eine blockweise Verschachtelung des Eingabedatensignals vornimmt. Die Ausgänge der beiden Faltungscodierer RSC1 und RSC2 sind jeweils über Punktierer PKT1 bzw. PKT2 mit einer Multiplexereinrichtung MUX verbunden. Der Multiplexereinrichtung MUX wird ferner eine Signalfolge X zugeführt, die identisch mit der digitalen Eingabesignalfolge U ist.

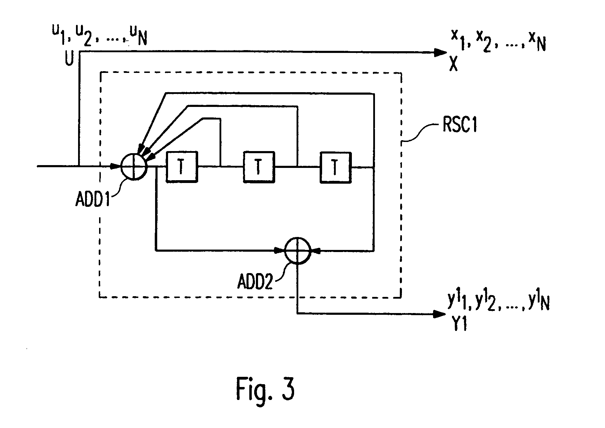

Fig. 3 zeigt am Beispiel von RSC1 den Aufbau eines rekursiven Faltungscodierers. Der Faltungscodierer RSC1 weist eingangsseitig einen ersten Addierer ADD1 und ein dem ersten Addierer ADD1 nachgeschaltetes Schieberegister mit z.B. drei Speicherzellen T auf. An seinem Ausgang stellt der Faltungscodierer RSC1 eine Redundanz-Datenfolge Y1 = ($y1_1$, $y1_2$, .., $y1_N$) bereit, die von einem zweiten Addierer ADD2 gebildet wird.

Es wird deutlich, daß ein zu einem bestimmten Zeitpunkt n am Ausgang vorliegendes Redundanz-Datensymbol $y1_n$ (n = 1, 2, .., N) von dem aktuellen Eingabe-Datensymbol $u_n$ der Eingabesignalfolge U sowie von dem Zustand des Schieberegisters abhängt.

Der Aufbau des zweiten Faltungscodierers RSC2 ist identisch mit dem Aufbau des ersten Faltungscodierers RSC1; an seinem Ausgang stellt RSC2 eine Redundanz-Datenfolge Y2 = ($y2_1$, $y2_2$, .., $y2_N$) bereit.

Die Signalfolge X kann als zweiter Ausgang des ersten Faltungscodierers RSC1 angesehen werden, das heißt bei dieser Betrachtungsweise umfaßt der erste Faltungscodierer RSC1 einen zweiten Ausgang, an dem die Datenfolge X ausgegeben wird, deren Elemente $x_1$, $x_2$, .., $x_N$ identisch mit den Elementen $u_1$, $u_2$, .., $u_N$ der Eingabesignalfolge U sind. Analoges gilt für den zweiten Faltungscodierer RSC2 und einen zweiten Ausgang X_I (nicht dargestellt) desselben, der identisch mit der verschachtelten Eingabesignalfolge U ist. Codierer mit dieser Eigenschaft werden als systematische Codierer bezeichnet.

Es werden dann pro Eingabe-Datensymbol $u_n$ von jedem Faltungscodierer RSC1 bzw. RSC2 genau zwei Ausgabe-Datensymbole $x_n$ und $y1_n$ bzw. $x\_l_n$ (verschachtelte systematische Information) und $y2_n$ ausgegeben. Jeder Faltungscodierer RSC1, RSC2 weist somit eine Coderate $R_C = 0,5$ auf.

Die Multiplexereinrichtung MUX dient zur Einstellung der Coderate des Turbo-Codierers TCOD. Um auch für TCOD eine Coderate von z.B. $R_C = 0,5$ zu erreichen, werden die beiden Redundanz-Teilfolgen Y1 und Y2 beispielsweise alternierend punktiert und multiplexiert. Die sich dabei ergebende Redundanz-Datenfolge $Y = (y1_1, y2_2, y1_3, y2_4, .., y1_N, y2_N)$ wird nachfolgend alternierend mit der systematischen Datenfolge X multiplexiert. Das sich bei dieser (speziellen) Form der Turbocodierung ergebende fehlerschutzcodierte Datensignal weist demzufolge (N sei als eine gerade Zahl angenommen) beispielsweise die Form $D = (x_1, y1_1, x_2, y2_2, x_3, y1_3, x_4, y2_4, .., x_N, y2_N)$ auf.

Der Faltungscodierer RSC1 kann als endlicher, getakteter Automat aufgefaßt und durch ein sog. Trellis-Diagramm mit M möglichen Zuständen beschrieben werden. Das Trellis-Diagramm des Faltungscodierers RSC1 mit einem Schieberegister aus 3 Zellen weist $M = 2^3 = 8$ Knoten auf, die den möglichen Zuständen des Schieberegisters entsprechen. Ein (beliebiger) erster Zustand m', der durch Eingabe eines Eingangsbits ($u_n = 0$ oder 1) in einen zweiten Zustand m übergeht, ist mit diesem im Trellis-Diagramm durch eine Verbindungslinie verbunden. Jede Redundanz-Teilfolge Y1 entspricht einem bestimmten Weg entlang Verbindungslinien durch das Trellis-Diagramm des RSC1-Codierers.

Trellis-Diagramme zur Veranschaulichung der Zustände von Codierern sind bekannt und werden hier nicht näher erläutert.

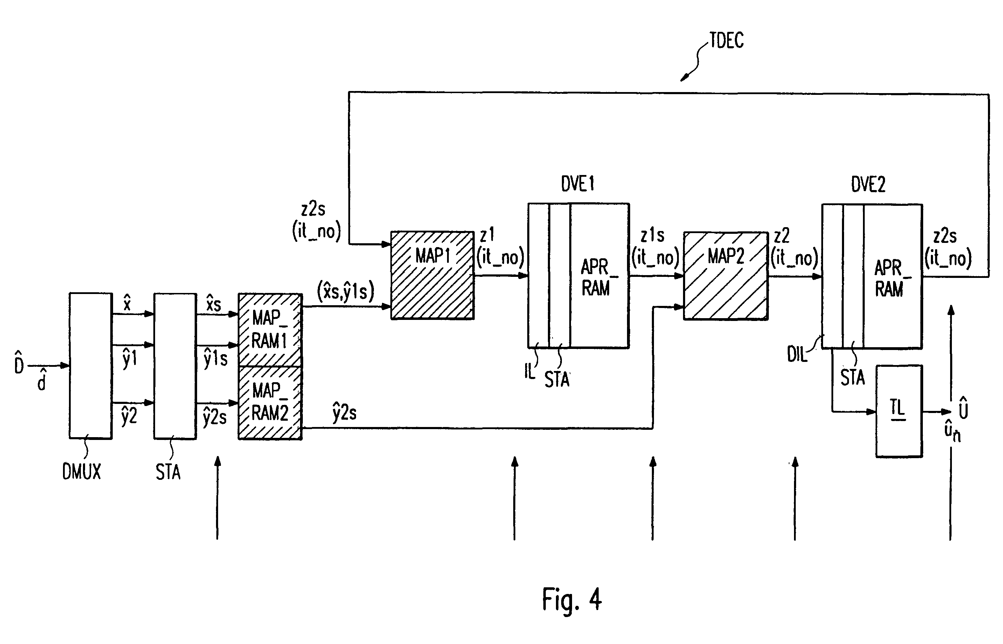

Fig. 4 zeigt ein Blockschaltbild zur Erläuterung der Arbeitsweise eines Ausführungsbeispiels eines erfindungsgemäßen Turbo-Decodierers TDEC.

Der Turbo-Decodierer TDEC umfaßt einen Demultiplexer DMUX, eine Statistik-Stufe STA, einen ersten und zweiten Speicher mit wahlfreiem Zugriff MAP_RAM1, MAP_RAM2, einen ersten und zweiten MAP-Symbolschätzer MAP1 und MAP2, eine erste und zweite Datenverarbeitungseinheit DVE1, DVE2 sowie eine Entscheidungslogik (Schwellenwertentscheider) TL.

Die erste Datenverarbeitungseinheit DVE1 umfaßt einen Turbo-Verschachteler IL, eine Statistik-Stufe STA und einen Datenspeicher APR_RAM. Die zweite Datenverarbeitungseinheit DVE2 umfaßt einen Entschachteler DIL, ebenfalls eine Statistik-Stufe STA und ebenfalls einen Datenspeicher APR_RAM.

Die von dem Demodulator DMOD dem Turbo-Decodierer TDEC zugeführte entzerrte Datenfolge $\hat{D} = (\hat{x}_1, \hat{y1}_1, \hat{x}_2, \hat{y2}_2, \hat{x}_3, \hat{y1}_3, \hat{x}_4, \hat{y2}_4, .., \hat{x}_N, \hat{y2}_N)$ wird von dem eingangsseitig vorgesehenen Demultiplexer DMUX in die entzerrte systematische Datenfolge $\hat{X}$ (detektierte Version der Eingabesignalfolge U ($= \hat{X}$)) und die beiden entzerrten Redundanz-Teilfolgen $\hat{Y1}$ und $\hat{Y2}$ (detektierte Versionen der Redundanz-Teilfolgen Y1 und Y2) aufgespalten. Mit $\hat{x}_n, \hat{y1}_n, \hat{y2}_n$ (n = 1, 2, .., N) werden die entzerrten (geschätzten) Versionen der senderseitig auftretenden Datensymbole $x_n, y1_n, y2_n$ bezeichnet. (In der Zeichnung sind die Indizes n der jeweiligen Folgenelemente aus Gründen der Übersichtlichkeit weggelassen.)

Die Datensymbole $\hat{x}_n$ (systematische Information) und $\hat{y1}_n, \hat{y2}_n$ (Redundanz-Information) werden der Statistik-Stufe STA zugeführt. Basierend auf der Kenntnis des momentanen Zustands des Übertragungskanals werden dort die statistischen Datenwerte $\hat{x}s_n, \hat{y1}s_n, \hat{y2}s_n$ gemäß der folgenden Gleichungen berechnet.

$$\hat{x}s_n = \hat{x}_n \cdot \mu_{\hat{x}n} / \sigma^2_{\hat{x}n}$$

$$\hat{y}1s_n = \hat{y}1_n \cdot \mu_{\hat{y}1n} / \sigma^2_{\hat{y}1n}$$

$$\hat{y}2s_n = \hat{y}2_n \cdot \mu_{\hat{y}2n} / \sigma^2_{\hat{y}2n} \qquad\qquad (1)$$

Dabei bezeichnen $\mu_{\hat{x}n}, \mu_{\hat{y}1n}, \mu_{\hat{y}2n}$ die Mittelwerte und $\sigma^2_{\hat{x}n}, \sigma^2_{\hat{y}1n}, \sigma^2_{\hat{y}2n}$ die Varianzen des weißen Rauschens bezüglich der zugehörigen Signalanteile.

Die statistischen Datensymbolwerte $\hat{x}s_n$ und $\hat{y1}s_n$ werden in dem Datenspeicher MAP_RAM1 abgelegt und die statistischen Datenwerte $\hat{y}2s_n$ werden in dem Datenspeicher MAP_RAM2 abgelegt. Die Speichergrößen von MAP_RAM1 und MAP_RAM2 sind jeweils so bemessen, daß die statistischen Datenwerte eines gesamten Blocks (z. B. N = 5120) Platz finden.

Auf der Grundlage der für einen Datenblock repräsentativen systematischen Information $\hat{x}s_n$ und Redundanz-Information $\hat{y1}s_n$ und $\hat{y2}s_n$ erfolgt eine iterative Turbo-Decodierung. Die Iterationsschleife wird in an sich bekannter Weise (siehe das eingangs genannte Buch von P. Jung) durch die Einheiten MAP1, DVE1, MAP2, DVE2 und die Rückführung von Rückkoppel-Information $z2s_n$ von DVE2 zu MAP1 gebildet.

Genauer gesagt berechnet der erste MAP-Symbolschätzer MAP1 auf der Basis der Eingangs-Datenwerte $xs_n$ und $y1s_n$ und einer Anfangs-Rückkoppel-Information $z2s_n$(it_no = 0) in einem ersten Iterationsschritt (it_no = 1) eine erste Folge von wertekontinuierlicher logarithmischer erster Zuverlässigkeitsinformation $z1_n$(it_no = 1). Diese erste Iterationsfolge logarithmischer Zuverlässigkeitsinformation wird in dem Turbo-Verschachteler IL verschachtelt und in der Statistik-Stufe STA statistisch aufbereitet. Die statistische Aufbereitung erfolgt nach der Gleichung

$$z1s_n = z1_n \cdot \mu_{z1n} / \sigma^2_{z1n} \tag{2}$$

Dabei bezeichnet $\mu_{z1n}$ den Mittelwert und $\sigma^2_{z1n}$ die Varianz des weißen Rauschens der ersten Zuverlässigkeitsinformation $z1_n$.

Zur Durchführung der genannten Prozeduren (Verschachtelung und statistische Aufbereitung) werden die Folgewerte $z1s_n$(it_no = 1) in dem Datenspeicher mit wahlfreiem Zugriff APR_RAM der ersten Datenverarbeitungseinheit DVE1 zwischengespeichert.

Die in der ersten Datenverarbeitungseinheit DVE1 bei der ersten Iteration erzeugten Datenwerte $z1s_n$(it_no = 1) der verschachtelten Folge von erster Zuverlässigkeitsinformation (erste Iteration) werden dem zweiten MAP-Symbolschätzer MAP2 zugeleitet. Dieser berechnet aus diesen Datenwerten und der Folge $y2s_n$ (für alle Iterationsdurchgänge identisch) eine Folge von zweiter logarithmischer Zuverlässigkeitsinformation $z2_n$(it_no = 1). Die einzelnen Werte der Folgen von erster und zweiter Zuverlässigkeitsinformation sind logarithmische a-Posteriori-Wahrscheinlichkeitsverhältnisse, sog. LLRs (Log-Likelihood Ratios).

Die Folge der zweiten Zuverlässigkeitsinformation $z2_n$(it_no = 1) wird dem Turbo-Entschachteler DIL und der Statistik-Stufe STA der zweiten Datenverarbeitungseinheit DVE2 zugeleitet und dort entschachtelt und statistisch aufbereitet. Die statistische Aufbereitung erfolgt nach der Gleichung

$$z2s_n = z2_n \cdot \mu_{z2n} / \sigma^2_{z2n} \tag{3}$$

Dabei bezeichnet $\mu_{z2n}$ den Mittelwert und $\sigma^2_{z2n}$ die Varianz des weißen Rauschens der zweiten Zuverlässigkeitsinformation $z2_n$.

Der Datenspeicher mit wahlfreiem Zugriff APR_RAM dient wiederum der Zwischenspeicherung der in der beschriebenen Weise erzeugten Datenwerte $z2s_n$(it_no = 1). Gemäß Fig. 4 stehen sie als Rückkoppel-Information dem ersten Symbolschätzer MAP1 während des nächsten Iterationsdurchlaufs (it_no = 2) zur Verfügung.

Nach einer vorgegebenen Anzahl von beispielsweise 5 Iterationsdurchläufen werden die am Ausgang des Turbo-Entschachtelers DIL der zweiten Datenverarbeitungseinheit DVE2 erzeugten Datenwerte $z2_n$(it_no = 5) (entschachtelt) einem Schwellenwertentscheider TL zugeleitet. Der Schwellenwertentscheider TL bestimmt für jedes Element der angegebenen Datenfolge mit einem Wert $\leq 0$ ein rekonstruiertes Datensymbol $\hat{u}_n = 0$ und für jedes Element der genannten Datenfolge mit einem Wert $> 0$ ein rekonstruiertes Datensymbol $\hat{u}_n = 1$.

Erfindungsgemäß sind die ersten und zweiten Symbolschätzer MAP1, MAP2 und die ersten und zweiten Datenverarbeitungseinheiten DVE1, DVE2 jeweils in Form ein und derselben Hardware-Struktur realisiert. Die im unteren Bereich der Fig. 4 eingezeichneten Pfeile kennzeichnen die mittels einer bidirektionalen Schnittstelle realisierten Datenübergabeorte, an welchen ein Datentransfer zwischen einem Symbolschätzer (enthält MAP1/2 und die zugeordneten Speicher MAP_RAM1/2, schraffiert gezeichnet) und einen digitalen Signalprozessor (enthält DVE1/2, ggf. DMUX, STA, TL, ohne Schraffur) bewerkstelligt wird.

Es sei erwähnt, daß insbesondere die Statistikstufe STA auch in Hardware ausgeführt und in dem Symbolschätzer integriert sein kann.

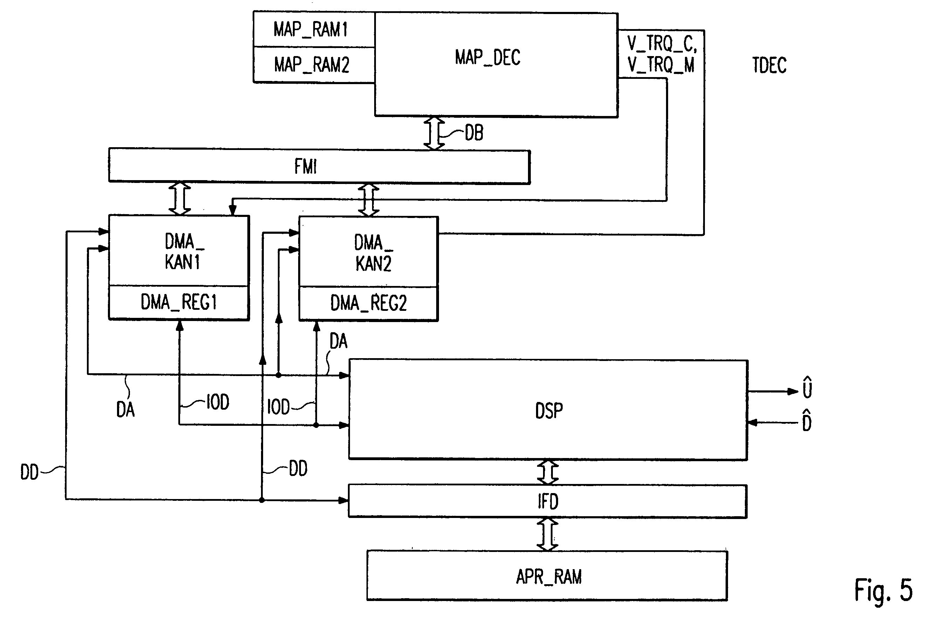

Fig. 5 zeigt ein Blockschaltbild des bereits anhand Fig. 4 beschriebenen Turbo-Decodierers TDEC.

Der Turbo-Decodierer TDEC umfaßt einen MAP-Decodierer MAP_DEC, welcher den beiden Symbolschätzern MAP1/2 in Fig. 4 entspricht und mit den beiden MAP-Datenspeichern MAP_RAM1 und MAP_RAM2 in Verbindung steht. Der MAP-Decodierer MAP_DEC ist über einen bidirektionalen Datenbus DB und eine FMI-(flexible memory interface-)Schnittstelle FMI mit zwei programmierbaren DMA-(direkter Speicherzugriff: direct memory access-)Kanälen DMA_KAN1 und DMA_KAN2 verbunden. Die "Lage" dieser FMI-Schnittstelle FMI mit zugeordneten DMA-Kanälen DMA_KAN1 und DMA_KAN2 im Turbo-Decodierablauf ist wie bereits erwähnt in der Fig. 4 durch die Pfeile angezeigt.

Die programmierbaren DMA-Kanäle DMA_KAN1/2 umfassen jeweils interne DMA-Register DMA_REG1, DMA_REG2. Die internen DMA-Register DMA_REG1/2 stehen über jeweilige Programmierleitungen IOD mit einem digitalen Signalprozessor DSP in bidirektionaler Datenaustauschverbindung.

Der DSP hat über Datenleitungen und eine interne DSP-Schnittstelle IFD Zugriff auf den Datenspeicher APR_RAM. Ferner stehen der DSP und die DSP-Schnittstelle IFD über eine bidirektionale Busstruktur bestehend aus einem Datenbus DD und einem Adressbus DA mit den DMA-Kanälen DMA_KAN1/2 in Datenaustauschverbindung.

Der DSP führt durch Abarbeitung einer herstellerseitig programmierten Software (Firmware) unter Zwischenspeicherung von Daten im Datenspeicher APR_RAM die statistischen Berechnungen sowie die Ver- und Entschachtelungsprozeduren (siehe Fig. 4) und gegebenenfalls auch die von den Einheiten DMUX und TL ausgeführten Datenverarbeitungsschritte durch.

Die Datenübermittlung über die DMA-Kanäle DMA_KAN1/2 sowie die FMI-Schnittstelle FMI zu dem MAP-Decodierer MAP_DEC wird über zwei Datenanforderungs-Steuersignale V_TRQ_M (Anforderung des Datentransfers über den ersten DMA-Kanal DMA_KAN1) und V_TRQ_C (Anforderung des Datentransfers über den zweiten DMA-Kanal DMA_KAN2) initiiert.

Über den ersten DMA-Kanal DMA_KAN1 werden die Eingabedaten für die erste und die zweite Symbolschätzung (MAP1- und MAP2-Modus) übertragen. Für die erste Symbolschätzung sind dies einerseits die statistischen Datenwerte der systematischen Information $\hat{x}s_n$ und die statistischen Datenwerte der ersten Redundanz-Information $\hat{y}1s_n$, welche lediglich einmal am Anfang eines Block-Decodierablaufes übertragen werden müssen, und andererseits sind dies die statistisch aufbereiteten Datenwerte $z2s_n(it\_no)$ der Rückkoppel-Information, die in jedem Iterationsdurchlauf der Turbo-Decodierung übertragen werden.

Ein bei einer Wortbreite von 16 Bit beispielsweise verwendetes Datenformat der Eingabewerte für die erste Symbolschätzung ist in den beiden Tabellen 1 und 2 dargestellt.

Tabelle 1

| (Datenübergabe für die erste Symbolschätzung, einmal pro Block) | | | |
|---|---|---|---|
| Bits 0-3 | Bits 4-7 | Bits 8-11 | Bits 12-15 |
| $\hat{x}s_1$ | | $\hat{y}1s_1$ | |
| $\hat{x}s_2$ | | $\hat{y}1s_2$ | |
| $\hat{x}s_3$ | | $\hat{y}1s_3$ | |
| ... | | ... | |
| ... | | ... | |
| $\hat{x}s_N$ | | $\hat{y}1s_N$ | |

Tabelle 2

| (Datenübergabe für die erste Symbolschätzung, bei jedem Iterationsdurchlauf) | | | |
|---|---|---|---|
| Bits 0-3 | Bits 4-7 | Bits 8-11 | Bits 12-15 |
| $z2s_1(it\_no=1\text{-}5)$ | | | |
| $z2s2(it\_no=1\text{-}5)$ | | | |
| $z2s3(it\_no=1\text{-}5)$ | | | |
| ... | | | |
| ... | | | |
| $z2sN(it\_no=1\text{-}5)$ | | | |

Für die zweite Symbolschätzung (MAP2-Modus) werden dem MAP-Decodierer MAP_DEC ebenfalls über den ersten DMA-Kanal DMA_KAN1, die bidirektionale FMI-Schnittstelle FMI und den Datenbus DB die statistischen Datenwerte der zweiten Redundanz-Information $\hat{y}2s_n$ und - bei jedem Iterationsdurchlauf - die statistisch aufbereiteten Datenwerte der ersten Zuverlässigkeitsinformation $z1s_n(it\_no)$ zugeleitet. Ein mögliches Datenformat der Datenübertragung ist in den Tabellen 3 und 4 dargestellt:

Tabelle 3

| (Datenübergabe für die zweite Symbolschätzung, einmal pro Block) | | | |
|---|---|---|---|
| Bits 0-3 | Bits 4-7 | Bits 8-11 | Bits 12-15 |
| $\hat{y2s}_1$ | | | |
| $\hat{y2s}_2$ | | | |
| $\hat{y2s}_3$ | | | |
| ... | | | |
| ... | | | |
| $\hat{y2s}_N$ | | | |

Tabelle 4

| (Datenübergabe für die zweite Symbolschätzung, bei jedem Iterationsdurchlauf) | | | |
|---|---|---|---|
| Bits 0-3 | Bits 4-7 | Bits 8-11 | Bits 12-15 |
| z1s1(it_no=1-5) | | | |
| z1s2(it_no=1-5) | | | |
| z1s3(it_no=1-5) | | | |
| ... | | | |
| ... | | | |
| z1s$_N$(it_no=1-5) | | | |

Der zweite DMA-Kanal DMA_KAN2 dient der Übertragung der Ergebniswerte (Ausgabedaten) $z1_n$ und $z2_n$ der Symbolschätzer MAP1 bzw. MAP2 zum DSP.

Fig. 6 zeigt ein Blockschaltbild des MAP-Decodierers MAP_DEC.

Die über den Datenbus DB übertragenen Daten werden einer internen Schnittstelle IF übergeben.

Neben der internen Schnittstelle IF und den beiden MAP-Datenspeichern MAP_RAM1 (z.B. N x 16 Bit) und MAP_RAM2 (z.B. N x 8 Bit) umfaßt der MAP-Decodierer MAP_DEC einen Eingabedatenspeicher INP_APR, einen Ausgabedatenspeicher OUT_LLR, ein Konfigurations-Register V_CONF, eine DMA-Anforderungseinheit DMA_REQ zur Erzeugung der Anforderungs-Steuersignale V_TRQ_C und V_TRQ_M und ein Modul zum Erzeugen von standardspezifischer Code-Information (Trellis-Information) MAP_ST. Ferner umfaßt der MAP-Decodierer MAP_DEC eine Steuereinheit ST_TRANS zur Steuerung der Berechnung von Übergangs-Metrikwerten, eine Steuereinheit SL_WIN_FD zur Steuerung der Berechnung von Vorwärtsrekursions-Metrikwerten, eine Steuereinheit SL_WIN_BD zur Steuerung der Berechnung von Rückwärtsrekursions-Metrikwerten und eine Steuereinheit LLR_RAT zur Steuerung der Berechnung von Werten der ersten und zweiten Zuverlässigkeitsinformation $z1_n$(it_no) bzw. $z2_n$(it_no). Die vier Steuereinheiten stehen über einen internen Datenbus IDB mit einem drei Hardware-Rechenbausteine RB1, RB2, RB3 umfassenden Rechenmittel RM in Datenaustauschverbindung. Ferner kann über den internen Datenbus IDB auf zwei Datenspeicher für Vorwärtsrekursions-Metrikwerte, nämlich RAM_FD_0 und RAM_FD_1, beide z.B. 20 x 128 Bit groß, zugegriffen werden. RAM_FD_0 beinhaltet Vorwärtsrekursions-Metrikwerte, die aufgrund eines Übergangs mit einem Eingangsbit von 0 erzeugt werden. RAM_FD_1 beinhaltet Vorwärtsrekursions-Metrikwerte, die aufgrund eines Übergangs mit einem Eingangsbit von 1 erzeugt werden.

Die Funktionsweise des in Fig. 6 dargestellten MAP-Decodierers ist wie folgt:

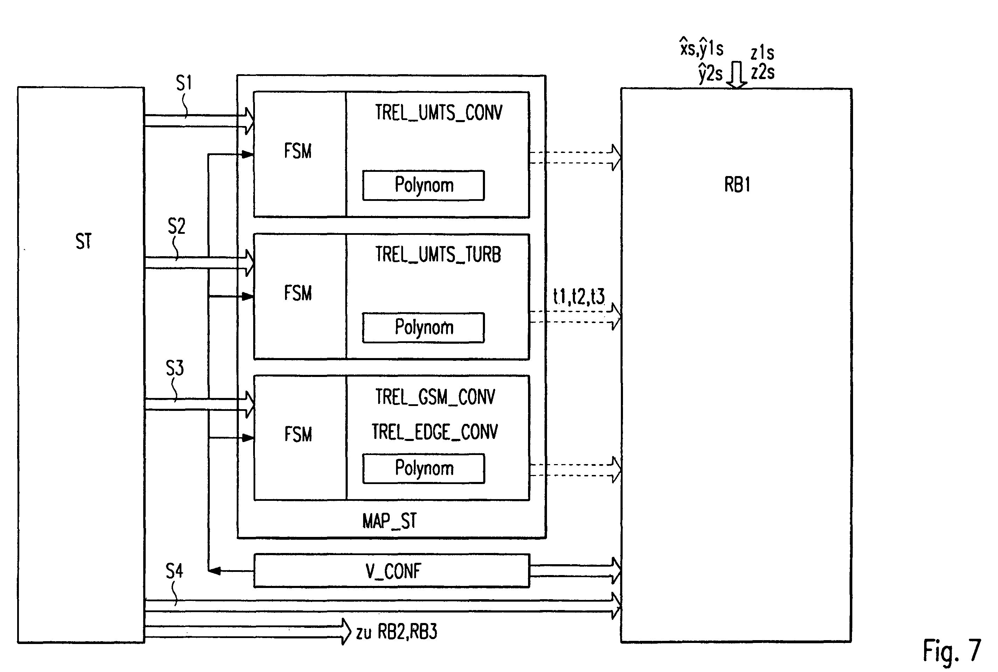

Im Rahmen eines Initialisierungsvorgangs wird dem MAP-Decodierer MAP_DEC über den Datenbus DB zunächst mitgeteilt, welcher Code der senderseitigen Codierung des zu übertragenden Datensignals zugrundeliegt. Unter den verfügbaren Codes ist erfindungsgemäß zumindest ein Turbo-Code. Entsprechend dem zugrundeliegenden Code werden in dem Modul MAP_ST codespezifische Eingangsdatenwerte für den ersten Rechenbaustein RB1 erzeugt. Dies wird in Verbindung mit Fig. 7 noch näher erläutert.

Zur Decodierung eines gesamten Datenblocks werden zunächst die Datenwerte $\hat{xs}_n$, $\hat{y1s}_n$ und $\hat{y2s}_n$ der (im DSP bereits statistisch aufbereiteten) systematischen Information und der ersten und zweiten Redundanz-Information für einen Datenblock (n = 1, .., N) in die Datenspeicher MAP_RAM1/2 geladen.

In einem ersten Rechenschritt führt der MAP-Decodierer MAP_DEC eine erste Symbolschätzung (MAP1-Modus) durch. Auf der Basis des Speicherinhalts von MAP_RAM1 und der Anfangs-Rückkoppel-Information $z2s_n$(it_no = 0) werden unter der Steuerung der Steuereinheit ST_TRANS in dem ersten Rechenbaustein RB1 Übergangs-Metrikwerte, unter der Steuerung der Steuereinheiten SL_WIN_FD und SL_WIN_BD in dem Rechenbaustein RB2 Vorwärts- und Rückwärtsrekursions-Metrikwerte und unter der Steuerung der Steuereinheit LLR_RAT mittels des dritten Rechenbausteins RB3 die logarithmischen Werte der ersten Zuverlässigkeitsinformation bezüglich des ersten Iterationsdurchlaufs $z1_n$(it_no = 1) erzeugt. Diese Werte werden über den Ausgabedatenspeicher OUT_LLR, die interne Schnittstelle IF und den Datenbus DB dem DSP zugeleitet.

Wie bereits anhand von Fig. 4 beschrieben, werden die von dem DSP erzeugten (verschachtelten und statistisch aufbereiteten) Datenwerte $z1s_n$(it_no = 1) nach Anforderung mittels des Steuersignals V_TRQ_C zum MAP-Decodierer MAP_DEC zurückgegeben und zunächst in dem Eingabedatenspeicher INP_APR zwischengespeichert.

Der MAP-Decodierer MAP_DEC führt nun eine zweite Symbolschätzung (MAP2-Modus) durch, d.h., daß die vorstehend beschriebene Berechnungsprozedur jetzt auf der Grundlage der im zweiten MAP-Datenspeicher MAP_RAM2 gespeicherten Datenwerte ($\hat{y}2s_n$) und den in dem Eingabedatenspeicher INP_APR zwischengespeicherten Werte durchgeführt wird. Die Ausgabe der Werte der zweiten Zuverlässigkeitsinformation $z2_n$(it_no = 1) erfolgt wiederum über den Ausgabedatenspeicher OUT_LLR.

Nachfolgend wird die Berechnung der LLRs mittels Vorwärts- und Rückwärtsrekursion anhand der Berechnung der ersten Zuverlässigkeitsinformation $z1_n$ kurz erläutert.

Jeder Wert $z1_n$ ist ein wertekontinuierliches, logarithmisches Wahrscheinlichkeitsverhältnis für das uncodierte Datensymbol $u_n$ der Eingabesignalfolge U,

$$z1_n = \ln\left\{\frac{P\left(u_n = 1 \middle| \hat{X}, \hat{Y}1, Z2\right)}{P\left(u_n = 0 \middle| \hat{X}, \hat{Y}1, Z2\right)}\right\} \qquad (4)$$

Mit $P(u_n = 1 | \hat{X}, \hat{Y}1, Z2)$ bzw. $P(u_n = 0 | \hat{X}, \hat{Y}1, Z2)$ werden die bedingten Wahrscheinlichkeiten dafür bezeichnet, daß das Datensymbol $u_n$ gleich 1 bzw. gleich 0 ist unter der Bedingung, daß die Folgen X,Y1,Z2 beobachtet werden. Diese bedingten Wahrscheinlichkeiten sind "Wahrscheinlichkeiten a-Posteriori", da von einem eingetretenen Ereignis (den "gemessenen" Folgen X,Y1,Z2) auf die Wahrscheinlichkeiten der diesem Ereignis zugrundeliegenden, uncodierten Datensymbole $u_1$ bis $u_N$ rückgeschlossen wird.

Der Zustand des senderseitigen Faltungscodierers RSC1 zum Zeitpunkt n (d.h. beim Eingabe-Datensymbol $u_n$) wird mit $S_n$ bezeichnet.

Die bedingten a-Posteriori-Wahrscheinlichkeiten in der Gleichung (4) lassen sich als Summen von Einzel-a-Posteriori-Wahrscheinlichkeiten über die $M = 2^{L-1}$ möglichen Zustände $S_n = 0, 1, .., M-1$ des Codierers RSC1 ausdrükken, wobei mit L die Rückgriffstiefe des erzeugten Turbo-Codes bezeichnet wird:

$$z1_n = \ln\left\{\frac{\sum_{m=0}^{M-1} P\left(u_n = 1, S_n = m \middle| \hat{X}, \hat{Y}1, Z2\right)}{\sum_{m=0}^{M-1} P\left(u_n = 0, S_n = m \middle| \hat{X}, \hat{Y}1, Z2\right)}\right\} \qquad (5)$$

Die Einzelwahrscheinlichkeiten können in der folgenden Form geschrieben werden

$$P(u_n = i, S_n = m | \hat{X}, \hat{Y}1, Z2) = \alpha_n^i(m) \cdot \beta_n(m) \qquad i = 0, 1$$

mit

$$\alpha_n^i(m) = P(u_n = i, S_n = m | R_1^N)$$

$$\beta_n(m) = \frac{p(R_{n+1}^N|S_n = m)}{p(R_{n+1}^N|R_1^N)} \tag{6}$$

wobei zur Vereinfachung der Schreibweise die Folge

$$R_\nu^\mu = (R_\nu, .., R_\mu), \qquad 1 \le \nu < \mu \le N \tag{7}$$

bestehend aus den Wertetripeln $R_n = (\hat{x}_n, \hat{y}1_n, z2_n)$ von systematischer Information, Redundanz-Information und Rückkoppel-Information definiert wird.

Der Ausdrücke $\alpha_n^i(m)$ und $\beta_n(m)$ werden als Vorwärtsrekursionsund Rückwärtsrekursions-Metriken bezeichnet, da sie unter der Voraussetzung, daß die Übergangs-Metrikwerte $\gamma_n^i(R_n, m', m)$ bekannt sind, rekursiv ermittelt werden können. Die Übergangs-Metrikwerte $\gamma_n^i(R_n, m', m)$ sind die Übergangswahrscheinlichkeiten von einem ersten Zustand $S_{n-1} = m'$ in einen zweiten Zustand $S_n = m$ des Codierers RSC1 im Trellis-Diagramm, d.h.

$$\gamma_n^i(R_n, m', m) = P(u_n = i, S_n = m, R_n|S_{n-1} = m') \tag{8}$$

Eine detaillierte Beschreibung der Rekursionen (bei Verwendung einer (optimalen) MAP-Symbolschätzung) ist in dem Kapitel E.3.3 "Rekursive MAP-Symbolschätzung" des genannten Buchs von P. Jung auf den Seiten 353 bis 361 angegeben.

Die Rekursionen können über den gesamten Block laufen, d.h. die Vorwärtsrekursion beginnt beim Zeitpunkt $n = 1$ (erstes Bit der Folgen X, Y1, Z2: MAP1 bzw. der Folgen Y2, Z1 : MAP2) und endet im Zeitpunkt $n = N$ (letztes Bit der Folgen X, Y1, Z2: MAP1 bzw. der Folgen Y2, Z1 : MAP2) und die Rückwärtsrekursion beginnt beim Zeitpunkt $n = N$ und endet im Zeitpunkt $n = 1$. Eine andere Möglichkeit besteht in der Durchführung von jeweils mehreren segmentweisen Vorwärts- und Rückwärtsrekursionen, die den gesamten Block nach und nach (sowohl in Vorwärtsrichtung als auch in Rückwärtsrichtung) überdecken.

Nachfolgend wird die näherungsweise Berechnung der Übergangs-Metrikwerte, der Vorwärts- und Rückwärtsrekursions-Metrikwerte und der LLR's in dem MAP-Decodierer MAP_DEC (erstes Rechenmittel) anhand der Fig. 7, 8a-d und 9 näher erläutert.

Das Modul MAP_ST umfaßt drei Untermodule TREL_UMTS_CONV, TREL_UMTS_TURB, und TREL_GSM_CONV/TREL_EDGE_CONV. Alle Untermodule enthalten einen eigenen Zustandsgenerator FSM.

Eine Steuereinheit ST dient zur zeitlichen Steuerung und Koordination der Zustandsgeneratoren FSM und der Rechenbausteine RB1, RB2, RB3. Hierzu steht die Steuereinheit ST über Steuerdatenleitungen S1, S2 und S3 mit den Zustandsgeneratoren FSM der Untermodule TREL_UMTS_CONV, TREL_UMTS_TURB, TREL_GSM_CONV/ TREL_EDGE_CONV in Verbindung und steuert ferner über eine weitere Steuerdatenleitung S4 den ersten Rechenbaustein RB1. Weitere Steuerdatenleitungen führen zu den anderen Rechenbausteinen RB2, RB3.

Jedes Untermodul von MAP_ST berechnet theoretische Information (auch als Trellis-Information bezeichnet), welche für einen bestimmten Code charakteristisch ist. Die Berechnung der theoretischen Information erfolgt jeweils auf der Grundlage eines Code-spezifischen Polynoms. Den in den Untermodulen TREL_GSM_CONV bzw. TREL_EDGE_CONV berechneten Werten der theoretischen Information liegen die GSM-(Global System for Mobile Communication-) und EDGE-(enhanced data services for GSM evolution-)Standards zugrunde. Den von dem Untermodul TREL_UMTS_TURB berechneten theoretischen Werten t1, t2, t3 liegt der UMTS-(Universal Mobile Telecommunications Systems)Standard für Turbo-Decodierung zugrunde.

Im folgenden wird nur der Fall der Anwahl des Untermoduls TREL_UMTS_TURB durch V_CONF betrachtet.

In UMTS ist ein Turbo-Code der Rückgriffstiefe $L = 4$ vorgesehen. Folglich kann das Schieberegister des Faltungscodierers RSC1 im Turbo-Codierer (siehe Fig. 3) genau 8 Zustände einnehmen, nämlich 000, 001, 010, ... usw. In den Fig. 8a und 8b ist jeder dieser 8 möglichen Zustände durch ein mit den Index-Zahlen $m = 0$ bis 7 durchnummeriertes Kästchen dargestellt.

Fig. 8a zeigt die Zustandsübergänge m' zu m, die auftreten, wenn der zunächst (bei Schritt k-1) in einem (beliebigen) Ausgangszustand befindliche Turbo-Codierer durch Hinzufügen eines Eingabebits $a_k$ des Wertes 0 (d.h. $i = 0$) in einen darauffolgenden Zustand (bei Schritt k) gebracht wird. Ein entsprechendes Schaubild, das die bei Hinzufügen eines Eingabebits $a_k$ des Wertes 1 (d.h. $i = 1$) auftretenden Zustandsübergänge darstellt, ist in Fig. 8b gezeigt.

Für jeden möglichen Zustandsübergang (von k-1 nach k) werden drei theoretische Werte t1(i), t2(i), t3(i) berechnet.

Die Werte t1(i) und t3(i) sind identisch mit dem hinzugefügten Eingabebit $a_k$ (d.h. t1(i) = t3(i) = i). Der Wert t2 wird durch das Code-spezifische Polynom berechnet.

Eine mögliche Berechnungsschaltung für den Wert t2 aus $a_k$ ist in Fig. 8d dargestellt. Die Berechnungsschaltung umfaßt ein aus drei Speicherzellen T bestehendes Schieberegister und vier Addierer ADD, die in der dargestellten Weise in der Schaltung angeordnet sind. Das Schieberegister wird von dem Zustandsgenerator FSM mit einen Ausgangszustand (z.B. m' = 0, d.h. (000)) belegt und mit einem Eingabebit $a_k$ versorgt. Bei Hinzufügen des Eingabebits $a_k = i$ werden die Werte t2(i), i = 0, 1, bezogen auf den jeweiligen Ausgangszustand, z.B. m' = 0, generiert. Dieser Vorgang wird für alle Ausgangszustände des Schieberegisters durchgeführt.

Nachfolgend wird anhand Fig. 9 der Aufbau der Rechenbausteine RB1, RB2 und RB3 erläutert. Die Rechenbausteine RB1, RB2, RB3 sind schnelle Datenpfade, die komplett aus kombinatorischer Logik aufgebaut sind.

Der zur Berechnung der Übergangs-Metrikwerte $\gamma_n^i(R_n, m', m)$ vorgesehene erste Rechenbaustein RB1 nimmt die für $a_k = i$, i = 0, 1 erzeugten theoretischen Werte t1(i), t2(i), t3(i) entgegen und setzt diese in einem Schaltkreis GW in Gewichtsfaktoren w1(i), w2(i), w3(i) um. Die Gewichtsfaktoren w1(i), w2(i), w3(i) berechnen sich nach:

$$w1(i) = 1-2 \cdot t1(i)$$

$$w2(i) = 1-2 \cdot t2(i)$$

$$w3(i) = 1-2 \cdot t3(i) \tag{9}$$

Die Gewichtsfaktoren w1(i), w2(i), w3(i) sind Vorzeichenwerte, d.h. +1, -1. Mit diesen Vorzeichenwerten werden nun durch Multiplikation mit den "Meßwerten" die Übergangs-Metrikwerte $\gamma_n^i(R_n, m', m)$ berechnet.

Bei der ersten Symbolschätzung (MAP1-Modus) stehen als Meßwerte $xs_n$, $y1s_n$ und die Rückkoppel-Information $z2s_n(it\_no)$ zur Verfügung. Die Berechnung der Übergangs-Metrik eines bestimmten der insgesamt 16 Übergänge (siehe Fig. 8a und 8b) erfolgt nach der Gleichung

$$\gamma_n^i(R_n, m', m) = w1(i) \cdot \hat{x}s_n + w2(i) \cdot \hat{y}1s_n + w3(i) \cdot z2s_n (it\_no) \tag{10}$$

Da w1(i), w2(i), w3(i) Vorzeichenwerte sind, kann $\gamma_n^i(R_n, m', m)$ maximal 8 verschiedene Werte annehmen. Da diese Werte symmetrisch zu 0 sind, müssen nur 4 Werte und ihre jeweiligen negierten Werte berechnet werden.

Diese Berechnungen werden parallel, d.h. gleichzeitig mit 4 Addierern TR_ADD_1, TR_ADD_2, .., TR_ADD_4 (von denen jeder gemäß Gl. (10) drei Eingänge aufweist) und der nachgeschalteten Zweier-Komplement-Stufe 2K in RB1 durchgeführt. Die Zweier-Komplement-Stufe 2K bildet zu einem berechneten Wert den entsprechenden negierten Wert.

Der Zweier-Komplement-Stufe 2K ist ein Demultiplexer (nicht dargestellt) nachgeschaltet. Dieser verteilt die 8 berechneten Übergangs-Metrikwerte $\gamma_n^i(R_n, m', m)$ auf 4 Speicher BF1, BF2, .., BF4 mit jeweils 4 Speicherplätzen.

Die Verteilung wird so vorgenommen, daß in jedem Speicher BF1-4 die Übergangs-Metrikwerte $\gamma_n^i(R_n, m', m)$ eines "Butterfly" abgespeichert sind. Ein Butterfly bezeichnet eine Gruppe bestehend aus 4 bestimmten Übergangs-Metrikwerten $\gamma_n^i(R_n, m', m)$. In Fig. 8c sind die 4 Butterflies dargestellt. Der erste Butterfly B1 umfaßt die 4 Übergangs-Metrikwerte, die auf die Endzustände 0 und 1 hinführen, der zweite Butterfly B2 umfaßt die 4 Übergangs-Metrikwerte, die auf die Endzustände 2 und 3 hinführen, .., und der vierte Butterfly B4 umfaßt die 4 Übergangs-Metrikwerte, die auf die Endzustände 6 und 7 hinführen.

Bei der zweiten Symbolschätzung (MAP2-Modus) stehen lediglich zwei "Meßwerte" $\hat{y}2s_n$ und $z1s_n(it\_no)$ zur Verfügung. Die Berechnung des Übergangs-Metrikwerts eines bestimmten der insgesamt 16 Übergänge erfolgt nach der Gleichung:

$$\gamma_n^i(G_n, m', m) = w2(i) \cdot \hat{y}2s_n + w3(i) \cdot z1s_n(it\_no) \tag{11}$$

(hierbei wird mit $G_n$ die Folge bestehend aus den Wertepaaren $(z1_n, \hat{y}2_n)$ bezeichnet).

Da nur zwei Vorzeichenwerte w2(i), w3(i) zu berücksichtigen sind, kann $\gamma_n^i(G_n, m', m)$ maximal 4 verschiedene Werte annehmen. Diese Werte können entweder von den 4 Addierern TR_ADD_1-4 direkt oder durch 2 Addierer und die nachgeschaltete Zweier-Komplement-Stufe 2K berechnet werden.

Der weitere Verarbeitungsweg ist wie beim MAP1-Modus.

Die Steuerung des Rechenbausteins RB1 zur Kombination der theoretischen Werte (bzw. der Gewichtsfaktoren) mit den "Meßwerten" gemäß-den Gleichungen (10) oder (11) erfolgt durch die Steuereinheit ST_TRANS.

Die 16 berechneten Übergangs-Metrikwerte werden durch vier parallele Datenbusleitungen (jeweils eine Datenbusleitung pro Speicher BF1-4) dem zweiten Rechenbaustein RB2 zugeleitet.

Der zweite Rechenbaustein RB2 führt die rekursive Berechnung der Vorwärts- und Rückwärtsrekursions-Metrikwerte durch. Er weist 16 parallel angeordnete Addierer ADD_1, ADD_2, .., ADD_16, 8 parallel angeordnete Maximum-Einheiten MAX1, MAX2, .., MAX8 und 4 parallel angeordnete Zwischenspeicher ZS1, ZS2, ZS3 und ZS4 auf.

Jeder der Addierer ADD_1-4 addiert einen Übergangs-Metrikwert zu einem Vorwärts- oder Rückwärtsrekursions-Metrikwert, welcher im vorhergehenden Iterationsschritt bestimmt wurde - d.h. im Fall der Vorwärtsrekursion zu einem Ausgangszustand und im Fall der Rückwärtsrekursion zu einem Endzustand.

Für die Berechnung der Vorwärtsrekursions-Metrikwerte betrachten wir zunächst exemplarisch das Butterfly B1. Der erste Addierer ADD_1 addiert zu dem im vorhergehenden Rekursionsschritt errechneten Vorwärtsrekursions-Metrikwert $\alpha_{n-1}(m' = 0)$ die Übergangs-Metrik $\gamma_n^0(R_n, m' = 0, m = 0)$, wobei sich ein erster möglicher Wert $\alpha_n^0(m = 0)$ für den neuen Vorwärtsrekursions-Metrikwert $\alpha_n(m = 0)$ ergibt, und der zweite Addierer ADD_2 addiert zu dem im vorhergehenden Rekursionsschritt errechneten Vorwärtsrekursions-Metrikwert $\alpha_{n-1}(m' = 4)$ die Übergangs-Metrik $\gamma_n^1(R_n, m' = 4, m = 0)$, wobei sich ein zweiter möglicher Wert $\alpha_n^1(m = 0)$ für den neuen Vorwärtsrekursions-Metrikwert $\alpha_n(m = 0)$ ergibt. Der hochgestellte Index der möglichen Vorwärtsrekursions-Metrikwerten gibt das den jeweiligen Übergang bewirkende Eingabebit an.

Diese beiden Möglichkeiten, zum Endzustand m = 0 zu gelangen, sind gemäß dem obersten in Fig. 8c dargestellten Butterfly B1 alternativ.

Die weiteren Addierer arbeiten in analoger Weise, d.h. die Addierer ADD_3 und ADD_4 berechnen entsprechende Ausdrücke bezüglich der beiden Alternativen, um zu dem anderen Endzustand m = 1 des erstes Butterfly B1 zu gelangen, usw..

Allgemein gilt, daß jedem solchen alternative Übergangs-Metrikwerte verarbeitenden Paar von Addierern ADD_1/2, ADD_3/4, .., ADD_15/16 jeweils eine Maximum-Einheit MAX1, MAX2, .., MAX8 nachgeschaltet ist. Die Maximum-Einheiten MAX1, MAX2, .., MAX8 wählen durch Verwerfen jeweils des kleineren der beiden möglichen Werte $\alpha_n^0(m)$, $\alpha_n^1(m)$ für $\alpha_n(m)$ den wahrscheinlicheren der beiden alternativen Übergänge aus. Diese Vorwärtsrekursions-Metrikwerte $\alpha_n(m)$ bilden den Ausgangspunkt für den nächsten Rekursionsschritt n nach n+1.

In RB2 werden daher gleichzeitig 8 Vorwärtsrekursions-Metrikwerte $\alpha_n(m)$ für 4 Butterflies in paralleler Datenverarbeitung bestimmt. Die 8 berechneten Vorwärtsrekursions-Metrikwerte $\alpha_n(m)$ werden temporär zum Zwecke der Rekursionsberechnung in den Zwischenspeichern ZS1, ZS2, ZS3, ZS4 abgelegt. Die Ergebnisse $\alpha_n^0(m)$ und $\alpha_n^1(m)$ der Addierer ADD_1-16 werden über den Datenbus IDB den Vorwärtsrekursions-Speicherbereichen RAM_FD_0 bzw. RAM_FD_1 zugeleitet und dort abgespeichert. Sie werden später im Rechenbaustein RB3 verwendet.

Bei der in UMTS eingesetzten Datenrate von 384 kbit/s müssen alle 16 möglichen Vorwärtsrekursions-Metrikwerte $\alpha_n^0(m)$, $\alpha_n^1(m)$ innerhalb eines 52 MHz-Zyklus berechnet und in den Vorwärtsrekursions-Speicherbereichen RAM_FD_0 und RAM_FD_1 gespeichert werden.

Die Berechnung der Rückwärtsrekursions-Metrikwerte erfolgt analog, jedoch auf der Grundlage von Übergängen von einem Endzustand m zu einem Anfangszustand m'. Die bei der Rückwärtsrekursion für den betrachteten Zeitpunkt n berechneten Rückwärtsrekursions-Metrikwerte werden ebenfalls temporär (d.h. nur zum Zwecke der Rekursion zur Verwendung in dem jeweils nächsten Rekursionsschritt) in dem jeweiligen Zwischenspeicher ZS1, ZS2, ZS3 bzw. ZS4 abgelegt. Die Zwischenspeicher beinhalten somit die Vorwärts- und Rückwärtsrekursions-Metrikwerte eines Butterflies für einen bestimmten Zeitpunkt n.

Eine Abspeicherung der berechneten Rückwärtsrekursions-Metrikwerte über den Rekursionslauf ist (anders wie bei den Vorwärtsrekursions-Metrikwerten in RAM_FD_0 bzw. RAM_FD_1) nicht erforderlich, da die Rückwärtsrekursions-Metrikwerte im dritten Rechenbaustein RB3 sofort weiterverarbeitet werden können.

Der zur Berechnung der LLR-Ausgabewerte vorgesehene dritte Rechenbaustein RB3 umfaßt 16 Addierer L_ADD_1, L_ADD_2, .., L_ADD_16, zwei Maximum-Einheiten MAX_1 und MAX_2 sowie einen Subtrahierer SUB.

Der dritte Rechenbaustein RB3 setzt die in der Gleichung (5) angegebene Beziehung gemäß einem Näherungsausdruck

$$\max_{m = 0, \dots, 7} \{ \alpha_n^1(m) + \beta_n(m) \} \quad - \quad \max_{m = 0, \dots, 7} \{ \alpha_n^0(m) + \beta_n(m) \}$$

für die Berechnung der LLRs um. Der Näherungsausdruck ist in dem Artikel "Comparision of Turbo-Code Decoders Applied to Short Frame Transmission Systems", Peter Jung, IEEE Journal of Selected Areas in Communications, Vol. 14, No. 3, April 1996 vorgeschlagen, welcher durch Bezugnahme Gegenstand der vorliegenden Schrift wird. Die ersten 8 Addierer L_ADD_1-8 sind für die Addition der Vorwärtsrekursions-Metrikwerte zu i = 1 mit den zugehörigen Rückwärtsrekursions-Metrikwerten (d.h. für die Hypothese $u_n = 1$) zuständig, d.h. jeder Addierer bildet für einen der 8 Zustände die Summe $\alpha_n^1(m)+\beta_n(m)$. Die zweiten 8 Addierer L_ADD_9-16 sind für die Addition der Vorwärtsrekursions-Metrikwerte zu $i = 0$ mit den zugehörigen Rückwärtsrekursions-Metrikwerten (d.h. für die Hypothese $u_n = 0$) zuständig, d.h. jeder Addierer bildet für einen der 8 Zustände die Summe $\alpha_n^0(m)+\beta_n(m)$.

Die Maximum-Einheit MAX_1 nimmt die Ausgänge der ersten 8 Addierer L_ADD_1-8 entgegen und die Maximum-Einheit MAX_2 nimmt die Ausgänge der zweiten 8 Addierer L_ADD_9-16 entgegen. Jede Maximum-Einheit MAX_1 bzw. MAX_2 findet durch Vergleich aller acht Addierer-Ausgänge den jeweils maximalen Addierer-Ausgang und leitet diesen dem Subtrahierer SUB weiter. Damit ist unter allen Übergängen verursacht durch ein Eingabebit $i = 1$ durch MAX_1 der Wert mit der maximalem Wahrscheinlichkeit und unter allen Übergängen verursacht durch ein Eingabebit $i = 0$ durch MAX_2 der Wert mit der maximalem Wahrscheinlichkeit bestimmt. Der Subtrahierer SUB berechnet unter Anwendung der Logarithmus-Eigenschaft $\ln(a/b) = \ln(a) - \ln(b)$ als Differenz dieser Ergebniswerte die Zuverlässigkeitsinformation, d.h. den LLR-Wert $z1_n(it\_no)$ (im MAP1-Modus) bzw. den LLR-Wert $z2_n(it\_no)$ (im MAP2-Modus).

Da sowohl in dem zweiten Rechenbaustein RB2 als auch in dem dritten Rechenbaustein RB3 jeweils 16 Addierer enthalten sind, können diese beiden Rechenbausteine auch in einem gemeinsamen Rechenbaustein mit insgesamt ebenfalls nur 16 Addierern zusammengefaßt werden. In diesem Fall werden die 16 Addierer gemultiplext betrieben, d.h. die Vorwärts- und Rückwärtsrekursions-Metrikwerte und die LLRs müssen alternierend berechnet werden. Der Vorteil besteht in einer Reduzierung des Hardware-Aufwands.

**Patentansprüche**

1. Turbo-Decodierer zum Decodieren eines senderseitig mit einem Turbo-Code fehlerschutzcodierten, über einen gestörten Kanal übertragenen und in einem Empfänger (E) detektierten Datensignals (D), wobei

   die Decodierung des detektierten Datensignals (D) iterativ erfolgt, indem eine Rechenschleife enthaltend die folgenden Rechenschritte

   (a) erste Symbolschätzung eines Eingabe-Datensignals unter Berücksichtigung eines ersten Teilredundanz-Datensignals und eines Rückkoppel-Datensignals,
   (b) Verschachtelung des bei der ersten Symbolschätzung berechneten Datensignals,
   (c) zweite Symbolschätzung des verschachtelten Datensignals unter Berücksichtigung eines zweiten Teilredundanz-Datensignals, und
   (d) Entschachtelung des bei der zweiten Symbolschätzung berechneten Datensignals zur Ermittlung des Rückkoppel-Datensignals,

   mehrfach durchlaufen wird, und
   wobei der Turbo-Decodierer (TDEC)

   - ein erstes Rechenmittel (MAP_DEC) zur Durchführung der Rechenschritte (a) und (c)
   - ein zweites Rechenmittel (DSP) zur Durchführung der Rechenschritte (b) und (d) und
   - eine bidirektionale Schnittstelle (FMI) zur Übergabe von Daten zwischen den beiden Rechenmitteln (MAP_DEC, DSP)

   umfasst,
   **dadurch gekennzeichnet, daß**

   - das erste Rechenmittel (MAP_DEC) einen einzigen Symbolschätzer umfasst, welcher zeitlich abwechselnd zur Durchführung der Rechenschritte (a) und (c) eingesetzt wird, und
   - das zweite Rechenmittel (DSP) ein eine Software abarbeitender DSP ist.

2. Turbo-Decodierer nach Anspruch 1,
   **dadurch gekennzeichnet,**

   - **daß** die Rechenschleife ferner den Rechenschritt
   (bb) Berechnung von für den momentanen Kanalzustand repräsentativer statistischer Information enthält, und
   - **daß** dieser Rechenschritt von dem zweiten Rechenmittel (DSP) durchgeführt wird.

3. Turbo-Decodierer nach einem der vorhergehenden Ansprüche,

**dadurch gekennzeichnet,**

- **daß** der bidirektionalen Schnittstelle (FMI) zwei DMA-Kanäle (DMA_KAN1, DMA_KAN2) zugeordnet sind.

4. Turbo-Decodierer nach einem der vorhergehenden Ansprüche,
**dadurch gekennzeichnet,**

- **daß** das erste Rechenmittel (MAP_DEC) mit Kenntnis des senderseitig eingesetzten Fehlerschutzcodes

--- Übergangs-Metrikwerte,
--- Vorwärts- und Rückwärtsrekursions-Metrikwerte, und daraus
--- Ausgabewerte (LLR), die repräsentativ für die Wahrscheinlichkeit sind, mit der ein zu schätzendes Datensymbol des detektierten Datensignals einen bestimmten Wert hat, berechnet, und

- daß das erste Rechenmittel (MAP_DEC) einen aus kombinatorischer Logik aufgebauten Hardware-Rechenbaustein (RB1; RB2; RB3) zur Erzeugung zumindest einer Sorte dieser Werte enthält.

5. Turbo-Decodierer nach Anspruch 4,
**dadurch gekennzeichnet,**
**daß** das erste Rechenmittel (MAP_DEC)

- einen ersten aus kombinatorischer Logik aufgebauten Hardware-Rechenbaustein (RB1) zur Erzeugung von Übergangs-Metrikwerten,
- einen zweiten aus kombinatorischer Logik aufgebauten Hardware-Rechenbaustein (RB2) zur Erzeugung von Vorwärts- und Rückwärtsrekursions-Metrikwerten, und
- einen dritten aus kombinatorischer Logik aufgebauten Hardware-Rechenbaustein (RB3) zur Erzeugung von Ausgabewerten

umfaßt.

6. Verfahren zur Turbo-Decodiererung eines senderseitig mit einem Turbo-Code fehlerschutzcodierten, über einen gestörten Kanal übertragenen und in einem Empfänger (E) detektierten Datensignals (D), wobei die Decodierung des detektierten Datensignals (D) iterativ erfolgt, indem eine Rechenschleife enthaltend die folgenden Rechenschritte

(a) erste Symbolschätzung eines Eingabe-Datensignals unter Berücksichtigung eines ersten Teilredundanz-Datensignals und eines Rückkoppel-Datensignals,
(b) Verschachtelung des bei der ersten Symbolschätzung berechneten Datensignals,
(c) zweite Symbolschätzung des verschachtelten Datensignals unter Berücksichtigung eines zweiten Teilredundanz-Datensignals, und
(d) Entschachtelung des bei der zweiten Symbolschätzung berechneten Datensignals zur Ermittlung des Rückkoppel-Datensignals, mehrfach durchlaufen wird, und

wobei

- die Rechenschritte (a) und (c) der Rechenschleife von einem ersten Rechenmittel (MAP_DEC)
- die Rechenschritte (b) und (d) von einem zweiten Rechenmittel (DSP) durchgeführt werden, und
- innerhalb eines Rechenschleifendurchlaufs zweimal eine bidirektionale Datenübergabe zwischen den beiden Rechenmitteln (MAP_DEC, DSP) erfolgt,

**dadurch gekennzeichnet, daß**

- die Rechenschritte (a) und (c) durch einen einzigen Symbolschätzer, welcher zeitlich abwechselnd zur Durchführung der Rechenschritte (a) und (c) eingesetzt wird, in dem ersten Rechenmittel (MAP_DEC) ausgeführt werden, und
- die Rechenschritte (b) und (d) durch Abarbeitung eines Programms mittels eines DSP ausgeführt werden.

7. Verfahren nach Anspruch 6

**dadurch gekennzeichnet,**
**daß** die Rechenschritte (a) und (c) durch ein im wesentlichen oder vollständig in Hardware ausgeführtes erstes Rechenmittel (MAP_DEC) ausgeführt werden.

8. Verfahren nach Anspruch 6 oder 7
**dadurch gekennzeichnet,**
**daß** die Datenübergabe durch einen direkten Speicherzugriff erfolgt.

**Claims**

1. Turbo decoder for decoding a data signal (D) error-protection-coded with a turbo code at the transmitter end, transmitted via a disturbed channel and detected in a receiver (E), in which
the detected data signal (D) is decoded iteratively in that a computing loop containing the following computing steps

   (a) first symbol estimation of an input data signal, taking into consideration a first partly redundant data signal and a feedback data signal,
   (b) interleaving of the data signal calculated in the first symbol estimation,
   (c) second symbol estimation of the interleaved data signal, taking into consideration a second partly redundant data signal, and
   (d) deinterleaving the data signal calculated in the second symbol estimation, for determining the feedback data signal,

   is passed several times, and
   in which the turbo decoder (TDEC) comprises the following:

   - a first computing means (MAP_DEC) for carrying out the computing steps (a) and (c),
   - a second computing means (DSP) for carrying out the computing steps (b) and (d), and
   - a bidirectional interface (FMI) for transferring data between the two computing means (MAP_DEC, DSP),

   **characterized in that**

   - the first computing means (MAP_DEC) comprises a single symbol estimator which is used in a chronologically alternating fashion to carry out the computing steps (a) and (c), and
   - the second computing means (DSP) is a DSP which processes software.

2. Turbo decoder according to Claim 1, **characterized**

   - **in that** the computing loop also contains the computing step
   (bb) calculation of statistical information representing the instantaneous channel state, and
   - **in that** this computing step is carried out by the second computing means (DSP).

3. Turbo decoder according to one of the preceding claims, **characterized**

   - **in that** two DMA channels (DMA_KAN1, DMA_KAN2) are allocated to the bidirectional interface (FMI).

4. Turbo decoder according to one of the preceding claims, **characterized**

   - **in that** the first computing means (MAP_DEC) calculates, with knowledge of the error protection code used at the transmitter end,

     --- transition metric values,
     --- forward and reverse recursion metric values, and from these
     --- output values (LLR) which are representative of the probability with which a data symbol of the detected data signal, which is to be estimated, has a particular value, and

   - in that the first computing means (MAP_DEC) contains a hardware computing chip (RB1; RB2; RB3), constructed of combinatorial logic, for generating at least one type of these values.

5. Turbo decoder according to Claim 4, **characterized in that** the first computing means (MAP_DEC) comprises

- a first hardware computing chip (RB1), constructed of combinatorial logic, for generating transition metric values,
- a second hardware computing chip (RB2), constructed of combinatorial logic, for generating forward and reverse recursion metric values, and
- a third hardware computing chip (RB3), constructed of combinatorial logic, for generating output values.

6. Method for turbo decoding a data signal (D) error-protection-coded at the transmitter end, transmitted via a disturbed channel and detected in a receiver (E), in which
the detected data signal (D) is decoded iteratively in that a computing loop containing the following computing steps

(a) first symbol estimation of an input data signal, taking into consideration a first partly redundant data signal and a feedback data signal,
(b) interleaving of the data signal calculated in the first symbol estimation,
(c) second symbol estimation of the interleaved data signal, taking into consideration a second partly redundant data signal, and
(d) deinterleaving the data signal calculated in the second symbol estimation, for determining the feedback data signal,

is passed several times, and
in which

- the computing steps (a) and (c) of the computing loop are carried out by a first computing means (MAP_DEC)
- the computing steps (b) and (d) are carried out by a second computing means (DSP), and
- within one computing loop pass, a bidirectional data transfer between the two computing means (MAP_DEC, DSP) takes place twice,

**characterized in that**

- the computing steps (a) and (c) are executed in the first computing means (MAP_DEC) by means of a single system estimator which is used in a chronologically alternating fashion to carry out the computing steps (a) and (c), and
- the computing steps (b) and (d) are carried out by executing a program by means of a DSP.

7. Method according to Claim 6, **characterized**
**in that** the computing steps (a) and (c) are carried out by a first computing means (MAP_DEC) which is essentially or completely constructed in hardware.

8. Method according to Claim 6 or 7, **characterized**
**in that** the data transfer is effected by a direct memory access.

**Revendications**

1. Décodeur turbo pour le décodage d'un signal de données (D) codé pour la protection contre les erreurs du côté de l'émetteur avec un code turbo, transmis sur un canal parasité et détecté dans un récepteur (E),
dans lequel le décodage du signal de données détecté (D) s'effectue par itération en exécutant plusieurs fois une boucle de calcul contenant les étapes de calcul suivantes :

(a) première estimation de symbole d'un signal de données d'entrée en tenant compte d'un premier signal de données à redondance partielle et d'un signal de données en rétroaction,
(b) imbrication du signal de données calculé lors de la première estimation de symbole,
(c) deuxième estimation de symbole du signal de données imbriqué en tenant compte d'un deuxième signal de données à redondance partielle, et
(d) désimbrication du signal de données calculé lors de la deuxième estimation de symbole pour la détermination du signal de données en rétroaction, et

EP 1 269 632 B1

dans lequel le décodeur turbo (TDEC) comprend

- un premier moyen de calcul (MAP_DEC) pour l'exécution des étapes de calcul (a) et (c),
- un deuxième moyen de calcul (DSP) pour l'exécution des étapes de calcul (b) et (d), et
- une interface bidirectionnelle (FMI) pour le transfert de données entre les deux moyens de calcul (MAP_DEC, DSP),

**caractérisé par le fait que**

- le premier moyen de calcul (MAP_DEC) comprend un seul estimateur de symbole qui est utilisé en alternance dans le temps pour l'exécution des étapes de calcul (a) et (c), et
- le deuxième moyen de calcul (DSP) est un processeur de signal numérique DSP exécutant un logiciel.

**2.** Décodeur turbo selon la revendication 1,
    **caractérisé par le fait que**

- la boude de calcul contient aussi l'étape de calcul
    (bb) calcul d'informations statistiques représentatives de l'état momentané du canal, et
- cette étape de calcul est exécutée par le deuxième moyen de calcul (DSP).

**3.** Décodeur turbo selon l'une des revendications précédentes,
    **caractérisé par le fait que**

- deux canaux DMA (DMA_KAN1, DMA_KAN2) sont attribués à l'interface bidirectionnelle (FMI)

**4.** Décodeur turbo selon l'une des revendications précédentes,
    **caractérisé par le fait que**

- le premier moyen de calcul (MAP_DEC), connaissant le code de protection contre les erreurs utilisé du côté de l'émetteur, calcule

    --- des valeurs métriques de transition,
    --- des valeurs métriques de récurrence en avant et en arrière, et à partir de là
    --- des valeurs de sortie (LLR) qui sont représentatives de la probabilité avec laquelle un symbole de données à estimer du signal de données détecté a une certaine valeur, et

- le premier moyen de calcul (MAP_DEC) contient un module de calcul matériel (RB1 ; RB2 ; RB3) structuré à partir d'une logique combinatoire pour la production d'au moins une sorte de ces valeurs.

**5.** Décodeur turbo selon la revendication 4,
    **caractérisé par le fait que** le premier moyen de calcul (MAP_DEC) comprend

- un premier module de calcul matériel (RB1) structuré à partir d'une logique combinatoire et destiné à la production de valeurs métriques de transition,
- un deuxième module de calcul matériel (RB2) structuré à partir d'une logique combinatoire et destiné à la production de valeurs métriques de récurrence en avant et en arrière, et
- un troisième module de calcul matériel (RB3) structuré à partir d'une logique combinatoire et destiné à la production de valeurs de sortie.

**6.** Procédé de décodage turbo d'un signal de données (D) codé pour la protection contre les erreurs du côté de l'émetteur avec un code turbo, transmis sur un canal parasité et détecté dans un récepteur (E),
    dans lequel le décodage du signal de données détecté (D) s'effectue par itération en exécutant plusieurs fois une boucle de calcul contenant les étapes de calcul suivantes :

    (a) première estimation de symbole d'un signal de données d'entrée en tenant compte d'un premier signal de données à redondance partielle et d'un signal de données en rétroaction,
    (b) imbrication du signal de données calculé lors de la première estimation de symbole,
    (c) deuxième estimation de symbole du signal de données imbriqué en tenant compte d'un deuxième signal

17

de données à redondance partielle, et

(d) désimbrication du signal de données calculé lors de la deuxième estimation de symbole pour la détermination du signal de données en rétroaction,

et dans lequel

- les étapes de calcul (a) et (c) de la boucle de calcul sont exécutées par un premier moyen de calcul (MAP_DEC),
- les étapes de calcul (b) et (d) sont exécutées par un deuxième moyen de calcul (DSP), et
- à l'intérieur d'une exécution de boucle de calcul, on effectue deux fois un transfert de données bidirectionnel entre les deux moyens de calcul (MAP_DEC, DSP),

**caractérisé par le fait que**

- les étapes de calcul (a) et (c) sont exécutées dans le premier moyen de calcul (MAP_DEC) par un seul estimateur de symbole qui est utilisé en alternance dans le temps pour l'exécution des étapes de calcul (a) et (c), et
- les étapes de calcul (b) et (d) sont exécutées par mise en oeuvre d'un programme au moyen d'un processeur de signal numérique DSP.

**7.** Procédé selon la revendication 6,
   **caractérisé par le fait que** les étapes de calcul (a) et (c) sont exécutées par un premier moyen de calcul (MAP_DEC) réalisé globalement ou totalement sous forme matérielle.

**8.** Procédé selon la revendication 6 ou 7,
   **caractérisé par le fait que** le transfert de données s'effectue au moyen d'un accès direct en mémoire.

Fig. 1

Fig. 2

$u_1, u_2, ..., u_N$
U

$x_1, x_2, ..., x_N$
X

RSC1

ADD1

T    T    T

ADD2

$y^1_1, y^1_2, ..., y^1_N$
Y1

Fig. 3

EP 1 269 632 B1

TDEC

DVE1

DVE2

z2s
(it_no)

MAP1

z1
(it_no)

APR_
RAM

z1s
(it_no)

MAP2

z2
(it_no)

APR_
RAM

z2s
(it_no)

$(\hat{x}s,\hat{y}1s)$

IL   STA

DIL

STA

$\hat{D}$   $\hat{d}$

DMUX

$\hat{x}$

STA

$\hat{x}s$

MAP_
RAM1

$\hat{y}1$

$\hat{y}1s$

$\hat{y}2$

$\hat{y}2s$

MAP_
RAM2

$\hat{y}2s$

TL

$\hat{U}$
$\hat{u}_n$

Fig. 4

Fig. 5

Fig. 6

MAP_RAM1 5120x16bit
MAP_RAM2 5120x8bit
RM — RB1 RB2 RB3
RAM_FD_0 20x128bit
RAM_FD_1 20x128bit
IDB
MAP_DEC
SL_WIN_FD
ST_TRANS
LLR_RAT
SL_WIN_BD
DMA_REQ
MAP_ST
INP_APR
V_CONF
OUT_LLR
V_TRQ_C , V_TRQ_M
IF
DB

Fig. 7

Zuständе

$a_k = 0$

t1(0), t2(0), t3(0)

| 000 | [0] | → [0] |
| 001 | [1] | [1] |
| 010 | [2] | [2] |
| 011 | [3] | [3] |
| 100 | [4] | [4] |
| 101 | [5] | [5] |
| 110 | [6] | [6] |
| 111 | [7] | [7] |

k−1     k

**Fig. 8a**

Zuständе

$a_k = 1$

t1(1), t2(1), t3(1)

k−1     k

**Fig. 8b**

B1, B2, B3, B4

**Fig. 8c**

EP 1 269 632 B1

**Fig. 8d**

ADD

FSM

$a_k = i$

T   T   T

ADD   ADD   ADD

t2(i)

Fig. 9